Europäisches Patentamt

European Patent Office

Office européen des brevets

(11) Veröffentlichungsnummer: **0 412 284 A1**

# EUROPÄISCHE PATENTANMELDUNG

(21) Anmeldenummer: 90112428.9

(51) Int. Cl.5: **H01R 23/68**, H05K 1/14

(22) Anmeldetag: 29.06.90

(30) Priorität: 03.08.89 DE 3925648

(43) Veröffentlichungstag der Anmeldung:
13.02.91 Patentblatt 91/07

(84) Benannte Vertragsstaaten:
**DE FR IT**

(71) Anmelder: **ROBERT BOSCH GMBH**
**Postfach 10 60 50**
**D-7000 Stuttgart 10(DE)**

(72) Erfinder: **Hofmeister, Werner, Dipl.-Ing.**
**Hoehenstrasse 20**
**D-7130 Muehlacker(DE)**
Erfinder: **Schildhauer, Helmut**
**Koellestrasse 29**
**D-7000 Stuttgart 1(DE)**

(54) **Mindenstens zwei verschiedene elektronische Baugruppen aufweisende Leiterplatte.**

(57) Die Erfindung betrifft eine Leiterplatte, die mit mindestens zwei verschiedenen elektronischen Baugruppen, insbesondere Steuer- und Leistungsteil, bestückt ist, welche über Leiter mit Kontakten einer an einem Leiterplattenrand angeordneten Stekkerleiste verbunden sind. Für eine große elektromagnetische Verträglichkeit wird vorgeschlagen, daß zwischen den beiden jeweils im Aufbau zusammengefaßten Baugruppen (2,3) Anschlüsse (7) liegen, die mit den die eine Baugruppe (3) brückenförmig überspannenden Leitern (8) verbunden sind.

Fig. 1

## MINDESTENS ZWEI VERSCHIEDENE ELEKTRONISCHE BAUGRUPPEN AUFWEISENDE LEITERPLATTE

Stand der Technik

Die Erfindung betrifft eine Leiterplatte, die mit mindestens zwei verschiedenen elektronischen Baugruppen, insbesondere Steuer- und Leistungsteil, bestückt ist, welche über Leiter mit Kontakten einer an einem Leiterplattenrand angeordneten Stekkerleiste verbunden sind.

Es ist bekannt, auf einer Platine mehrere elektronische Baugruppen unterzubringen. Diese Baugruppen können unterschiedliche Funktionen erfüllen, so daß sie gegebenenfalls auch mit unterschiedlich hohem Spannungspotential betrieben werden. Dieses kann zu Problemen in Hinblick auf die elektromagnetische Verträglichkeit (EMV), also zu einer die Funktion beeinträchtigenden Störaus- und Störeinstrahlung führen. Insbesondere dann, wenn es sich bei den verschiedenen Baugruppen um ein Steuer- und um ein Leistungsteil handelt, treten die geschilderten Probleme der elektromagnetischen Verträglichkeit auf, da im Leistungsteil hohe Spannungen und Ströme vorliegen, die die im Steuerteil vorhandenen niedrigen Spannungen und Ströme leicht beeinflussen können. Da die Kontaktierung zu den Kontakten der Steckerleiste am Leiterplattenrand erfolgt, ist eine weitgehend gemeinsame Leitungsführung von Leistungs- und Steuerleitungen gegeben, was zu Überkopplungserscheinungen führt und insofern die elektromagnetische Verträglichkeit negativ beeinflußt.

Vorteile der Erfindung

Die erfindungsgemäße Leiterplatte mit den im Hauptanspruch genannten Merkmalen hat demgegenüber den Vorteil, daß eine gegenseitige elektromagnetische Störbeeinflussung der verschiedenen Baugruppen minimiert oder sogar eliminiert ist. Hierzu werden die Baugruppen jeweils im Aufbau zusammengefaßt, das heißt, sie werden flächenmäßig getrennt auf der Leiterplatte angeordnet. Im Grenzbereich der Baugruppen -also zwischen ihnen- sind Anschlüsse für eine Steckerleiste vorgesehen, welche über Leitungen mit den Baugruppen, insbesondere einem Leistungsteil bzw. mit der restlichen Schaltung -vorwiegend einem Digitalteil- verbunden sind. Dabei wird eine der Baugruppen oder Teile davon brückenförmig von den Leitern überspannt. Hierdurch ist eine gemeinsame Leitungsführung der verschiedenen Baugruppen auf ein Mindestmaß herabgesetzt, so daß schädliche Überkopplungen und Einstreuungen vermieden sind. Durch die flächenmäßige Trennung der einzelnen Baugruppen ist ebenfalls eine Verbesserung der elektromagnetischen Verträglichkeit gegeben. Überdies führt die erfindungsgemäße Anordnung zu einem kleinen Bauvolumen wegen kurzer Leitungen zur Steckerleiste und ermöglicht eine gute Wärmeableitung z. B. zum Gerätegehäuse.

Die Anschlüsse sind aufgrund des Überspannens der einen Baugruppe mit Abstand zum die Steckerleiste aufweisenden Leiterplattenrand angeordnet. Vorzugsweise ist vorgesehen, daß die Anschlüsse mindestens eine Anschlußreihe bilden, die parallel zur Längserstreckung der Steckerleiste verläuft. Dieser Aufbau gewährleistet, daß die einzelnen Leiter alle etwa die gleiche Länge aufweisen, so daß lange Leitungsführungen -wie sie im Stand der Technik aufgrund der verstreut über die Leiterplattenfläche angeordneten Bauelemente gegeben waren- vermieden sind.

Nach einem bevorzugten Ausführungsbeispiel sind zwei vorzugsweise zueinander parallele Anschlußreihen vorgesehen, die im wesentlichen jeweils mit der ihr benachbarten Baugruppe elektrisch verbunden sind. Hierdurch bleibt zum einen die Separierung der einzelnen Baugruppen auch im Hinblick auf die Anschlüsse erhalten und es sind zum anderen kurze Leitungsführungen gewährleistet.

Das Überspannen der einen Baugruppe erfolgt vorzugsweise durch L-förmig ausgebildete Leiter. Diese stehen mit ihrem einen Ende mit den Anschlüssen der Leiterplatte in Verbindung, wobei der eine, jeweils zugehörige Schenkel der L-förmigen Leiter senkrecht zur Leiterplattenebene verläuft und das andere, an einem abgebogenen, parallel zur Leiterplattenoberfläche verlaufenden Schenkel ausgebildete Ende an die Kontakte der Steckerleisten angeschlossen ist.

Bevorzugt handelt es sich bei der von den Leitern überspannten Baugruppe um das Leistungsteil und bei der anderen Baugruppe um das Steuerteil einer Schaltungsanordnung.

Vorzugsweise zielt die Erfindung darauf ab, daß das Leistungsteil und das Steuerteil Baugruppen eines elektronischen Steuergeräts eines Kraftfahrzeugs sind; mithin also ein Einsatz auf dem Gebiet der Kraftfahrzeugelektronik erfolgt.

Zeichnung

Die Erfindung wird im folgenden anhand der Figuren näher erläutert. Es zeigen:

Figur 1 eine Draufsicht auf eine Leiterplatte und
Figur 2 ein Querschnitt durch eine Leiterplatte.

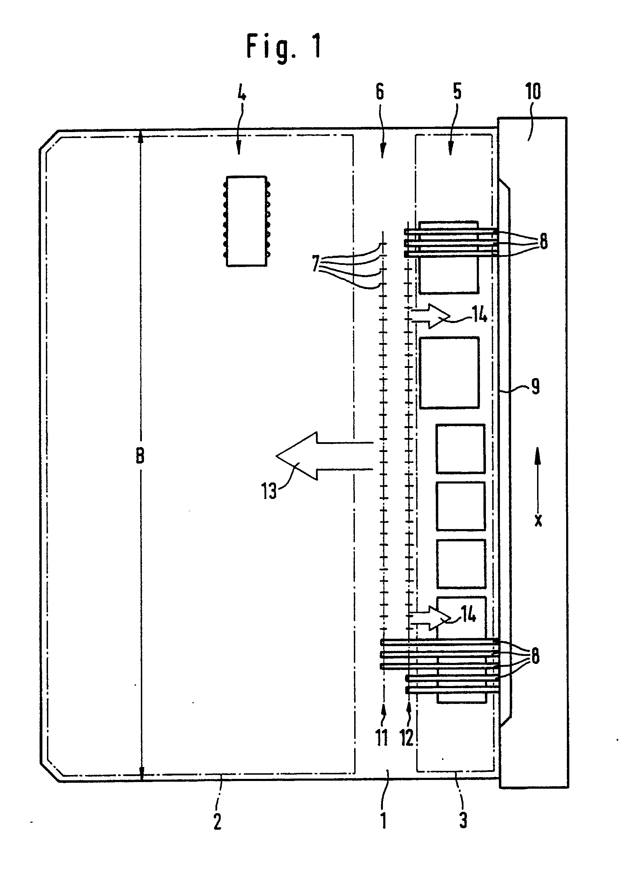

Die Figur 1 zeigt eine Leiterplatte 1, die beispielsweise als Metallkern-Leiterplatte ausgebildet sein kann. Sie ist mit einer in der Zeichnung nur angedeuteten ersten elektronischen Baugruppe 2 und einer weiteren, zweiten elektronischen Baugruppe 3 bestückt. Die Leiterplatte 1 gehört zu einem elektronischen Steuergerät der Kraftfahrzeugelektronik, das ein Steuerteil 4 und ein Leistungsteil 5 um faßt. Das Steuerteil 4 ist als erste Baugruppe 2 flächenmäßig zusammengefaßt auf der Leiterplatte 1 und das Leistungsteil 5 als flächenmäßig zusammengefaßte zweite Baugruppe 3 angeordnet. Mithin sind diese beiden Funktionsgruppen getrennt voneinander aufgebaut. Zwischen ihnen liegen in einer Grenzzone 6 befindliche Anschlüsse 7, die in der Figur 1 lediglich schematisch dargestellt sind. Die Anschlüsse 7 werden von dem Anschlußbereiche aufweisenden Enden der auf der Leiterplatte 1 ausgebildeten Leiterbahnen gebildet. Vorzugsweise sind die Anschlüsse 7 mit die Leiterplatte 1 durchsetzenden Bohrungen versehen, in die Leiter 8 mit ihren einen Enden eingesteckt und mit den Anschlüssen 7 verlötet sind. Die anderen Enden der Leiter 8 führen zu Kontakten einer an einem Leiterplattenrand 9 befestigten Steckerleiste 10.

Die Anschlüsse 7 der Grenzzone 6 bilden zwei parallel zueinander verlaufende Anschlußreihen 11, 12, die parallel zur Längserstreckung x der Steckerleiste 10 verlaufen. Die Anordnung ist derart ausgebildet, daß an die Steckerleiste 10 die zweite Baugruppe 3 angrenzt, die sich vorzugsweise über die gesamte Breite B der Leiterplatte 1 erstreckt und somit eine Zone bildet, die das Leistungsteil 5 des Steuergeräts aufweist. Hieran schließt sich die Grenzzone 6 an, die die beiden parallel zueinander verlaufenden Anschlußreihen 11 und 12 aufweist. Es folgt dann die erste Baugruppe 2, die das Steuerteil 4 des Steuergeräts umfaßt.

Der Anschluß an die Kontakte 7 der beiden Anschlußreihen 11 und 12 ist derart vorgenommen, daß die dem Steuerteil 4 benachbarte Anschlußreihe 11 im wesentlichen mit der ersten Baugruppe und daß das Leistungsteil 5 im wesentlichen mit den Kontakten 7 der benachbarten Anschlußreihe 12 über entsprechende Leiterbahnen der Leiterplatte 1 verbunden sind. Dieses wird zum einen durch den Pfeil 13 und zum anderen durch die beiden Pfeile 14 in der Figur 1 angedeutet.

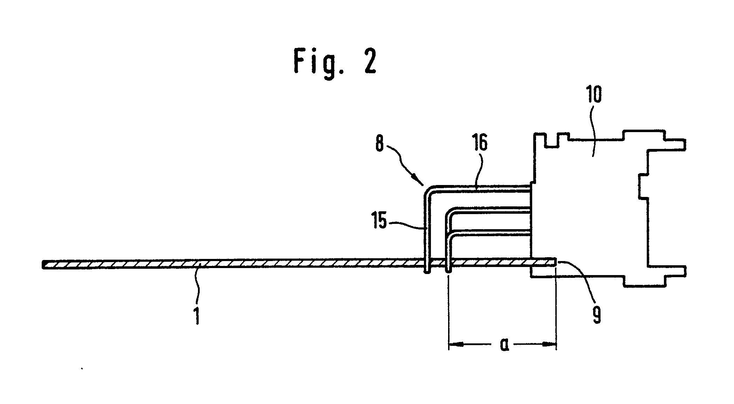

Die Leiter 8 sind L-förmig ausgebildet, wobei ihr einer, mit den Anschlüssen 7 verbundener Schenkel 15 senkrecht zur Ebene der Leiterplatte 1 und ihr zweiter, abgebogener Schenkel 16 parallel zur Ebene der Leiterplatte 1 verläuft (Figur 2).

Die Anschlußreihe 12 weist von dem Leiterplattenrand 9 einen Abstand a auf, der ausreicht, um dort das Leistungsteil 5 unterzubringen. Mithin überspannen die Leiter 8 frei die zweite Baugruppe 3.

Die Anordnung der Leiter 8 kann vorzugsweise derart erfolgen, daß benachbarte Leiter 8 zu entsprechend ausgesuchten Komponenten der beiden Baugruppen 2 und 3 führen derart, daß eine gegenseitige Störbeeinflussung nochmals minimiert und Überkopplungsmöglichkeiten demzufolge nochmals vermindert werden.

Vorzugsweise beträgt der Abstand a zwischen dem die Steckerleiste 10 aufweisenden Leiterplattenrand 9 und den Anschlüssen 7 0,5 bis 4 Zentimeter.

## Ansprüche

1. Leiterplatte, die mit mindestens zwei verschiedenen elektronischen Baugruppen, insbesondere einem Steuer- und einem Leistungsteil, bestückt ist, welche über Leiter mit Kontakten einer an einem Leiterplattenrand angeordneten Steckerleiste verbunden sind, **dadurch gekennzeichnet**, daß zwischen den beiden jeweils im Aufbau zusammengefaßten Baugruppen (2,3) Anschlüsse (7) liegen, die mit den die eine Baugruppe (3) brückenförmig überspannenden Leitern (8) verbunden sind.

2. Leiterplatte nach Anspruch 1, **dadurch gekennzeichnet**, daß die Anschlüsse (7) mit Abstand (a) zum die Steckerleiste (10) aufweisenden Leiterplattenrand (9) liegen.

3. Leiterplatte nach einem der vorhergehenden Ansprüche, **dadurch gekennzeichnet**, daß die Anschlüsse (7) mindestens eine Anschlußreihe (11,12) bilden, die im wesentlichen parallel zur Längserstreckung der Steckerleiste (10) verläuft.

4. Leiterplatte nach einem der vorhergehenden Ansprüche, **gekennzeichnet durch** zwei zueinander parallele Anschlußreihen (11,12), die im wesentlichen jeweils mit der ihr benachbarten Baugruppe (2,3) elektrisch verbunden sind.

5. Leiterplatte nach einem der vorhergehenden Ansprüche, **dadurch gekennzeichnet**, daß das Überspannen der einen Baugruppe (3) durch L-förmig ausgebildete Leiter (8) erfolgt.

6. Leiterplatte nach einem der vorhergehenden Ansprüche, **dadurch gekennzeichnet**, daß die überspannte Baugruppe (3) das Leistungsteil (5) und die andere Baugruppe (2) das Steuerteil (4) ist.

7. Leiterplatte nach einem der vorhergehenden Ansprüche, **dadurch gekennzeichnet**, daß das Leistungsteil (5) und das Steuerteil (4) Baugruppen (3,2) eines elektronischen Steuergeräts eines Kraftfahrzeugs sind.

# Fig. 1

# Fig. 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | DE-A-3 628 981 (BOSCH)<br>* Spalte 1, Zeilen 60-62; Spalte 2, Zeilen 51-62; Spalte 3, Zeilen 10-15; Figuren 2,3 * | 1,4 | H 01 R 23/68<br>H 05 K 1/14 |
| A | EP-A-0 178 540 (ALLIED CORPORATION)<br>* Seite 5, Absatz 3 - Seite 6, Absatz 1; Figuren 1-3 * | 1,3,5 | |

**RECHERCHIERTE SACHGEBIETE (Int. Cl.5)**

H 01 R 23/00
H 01 R 9/00
H 05 K 1/00
H 05 K 9/00

Der vorliegende Recherchenbericht wurde für alle Patentansprüche erstellt

| Recherchenort | Abschlußdatum der Recherche | Prüfer |
|---|---|---|
| Berlin | 02 November 90 | ALEXATOS G |